# EUROPEAN PATENT SPECIFICATION

(11) **EP 0 495 629 B1**
(45) Date of publication and mention of the grant of the patent: **19.04.1995**
(21) Application number: 92300312.3
(22) Date of filing: 14.01.1992
(51) Int. Cl.: H05K 7/10

(54) **Vertical lead-on-chip package**
Chipgehäuse mit Vertikalanschlüssen
Boîtier de puces avec connexions verticales

(30) Priority: 14.01.1991 US 640667
(43) Date of publication of application: 22.07.1992
(73) Proprietor: TEXAS INSTRUMENTS INCORPORATED, Dallas Texas 75265 (US)
(72) Inventor: Chiu, Anthony M., Richardson, Texas 75082 (US)
(74) Representative: Nettleton, John Victor

(56) References cited:
- EP-A- 0 216 363
- EP-A- 0 256 623
- DE-A- 2 257 888
- DE-B- 1 616 507

## Description

### FIELD OF THE INVENTION

This invention relates to semiconductor devices, and more particularly to a high density package for memory devices.

### BACKGROUND OF THE INVENTION

High speed computing and imaging systems constantly push the state-of-the-art in data storage. Present day imaging systems and computer systems with two or more processors require data input and output rates beyond the capability of conventional packaging.

To accomplish high data rates, the physical distance between the processor and the memory array must be kept to a minimum to avoid signal delays. The through-put of a large memory array using conventional packages is determined by the longest signal line between the processor and the memory chip, assuming the memory chips can run at the same clocking rate as the processor, generally at 50 mhz and above. The following described memory array package solves problems in memory density and distance.

### SUMMARY OF THE INVENTION

The invention as claimed is a high density packaging technique for memory arrays. A heat sink structure on each memory package serves as a heat sink, an assembly tool and tooling interface. An insulating material such as polyimide is placed on both sides of the chip and serves an insulation between closely mounted semiconductor devices. The package is suitable for both through-hole and surface mounting. Multiple devices are fixtured together for test and burn-in. The fixture is use to hold the devices during test and burn-in and then serves as a heat sink for the mounted array of devices. The packaging is suitable not only for memory chips, but any semiconductor driver/logic circuits by using the same package form factor.

The technical advance represented by the invention as well as the objects thereof will become apparent from the following description of a preferred embodiment of the invention when considered in conjunction with the accompanying drawings, and the novel features set forth in the appended claims.

### BRIEF DESCRIPTION OF THE DRAWINGS

FIGURE 1 is an isometric view of an array of memory devices;
FIGURE 2 is a front view of a surface mounted device;
FIGURE 3 is a side view of the surface mounted device;
FIGURES 3a and 3b illustrate two different contacts from the vertical lead to the semiconductor device;
FIGURE 4 is a front view of a through-hole assembly;
FIGURE 5 is a side view of the through-hole assembly;
FIGURE 6 illustrates a array of devices in a heat sink/holding fixture;
FIGURE 7 is a top view of a solder mask
FIGURE 8 shows a mounted array of devices;
FIGURE 9 is an enlarged view of the surface mount connection; and
FIGURE 10 illustrates the spring action of the heat sink.

### DESCRIPTION OF A PREFERRED EMBODIMENT

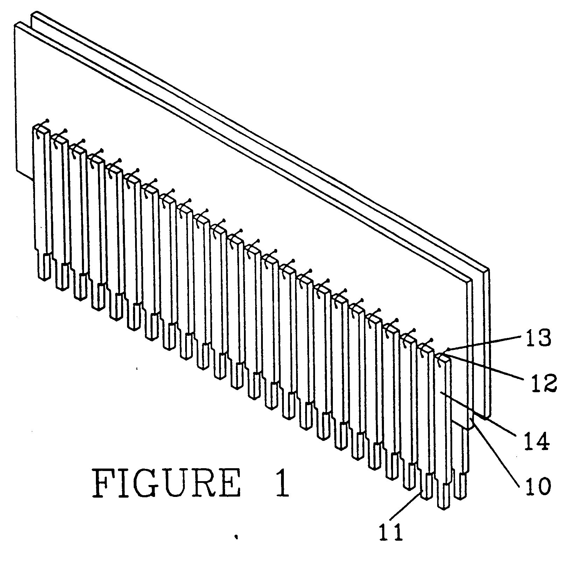

Figure 1 is representative of an array of semiconductor memory devices, illustrated without a heat sink. Each memory device 10 has a plurality of leads 14 connected to bond pads 13 on the device by connection wires 12. Each lead 14 may have a reduced size end 11.

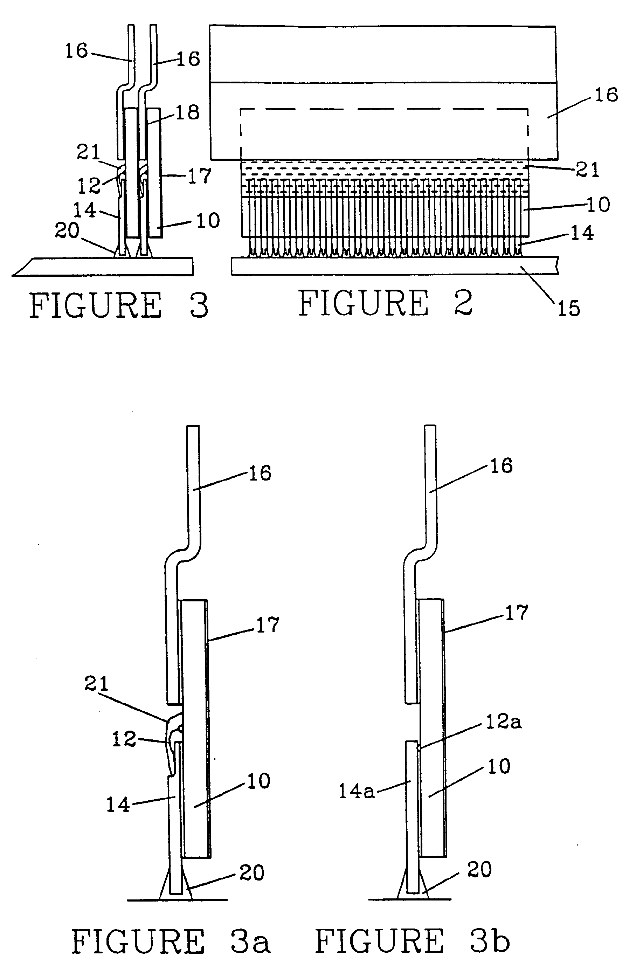

Figure 2 is a front view of the package of the present invention in which the devices are surface mounted, and Figure 3 is a side view showing two mounted devices. Device 10 has a heat sink 16 mounted on the top side, as illustrated, and the leads 14 connected on the bottom side of the device. The devices are surface mounted to a circuit board 15.

Side view, Figure 3, is an enlarged view showing more detail of each device, and the surface mounting feature. Each device 10 has an insulating coating 17 on the back side and a coating 18 over the front side. The insulating material may be, for example, polyimide. Coating 17, on the backside of the device prevents the back of one device from shorting the front of the adjacent device when the two devices are in contact. Insulating layer 18, on the front of the device, insulates heat sink 16 from the device, and also provides an insulating mounting surface for leads 14. A layer of insulating material 21 is placed over the bond wire 12, its connection to the bond pad 13 on the device 10, and its connection to the lead 14. Figure 3a is an enlarged view of the wire bond illustrated in Figure 3.

Figure 3b illustrates another way to bond the lead 14a to device 10. A contact bump 12a on device 10 is connected to lead 14a. This method is TAB or Tape Automated Bonding.

In surface mounting each device, leads 14 are joined to circuit board 15 by reflow solder. The solder 20 bonds leads 14 to electrical connections such as solder pads (not illustrated) on circuit board 15.

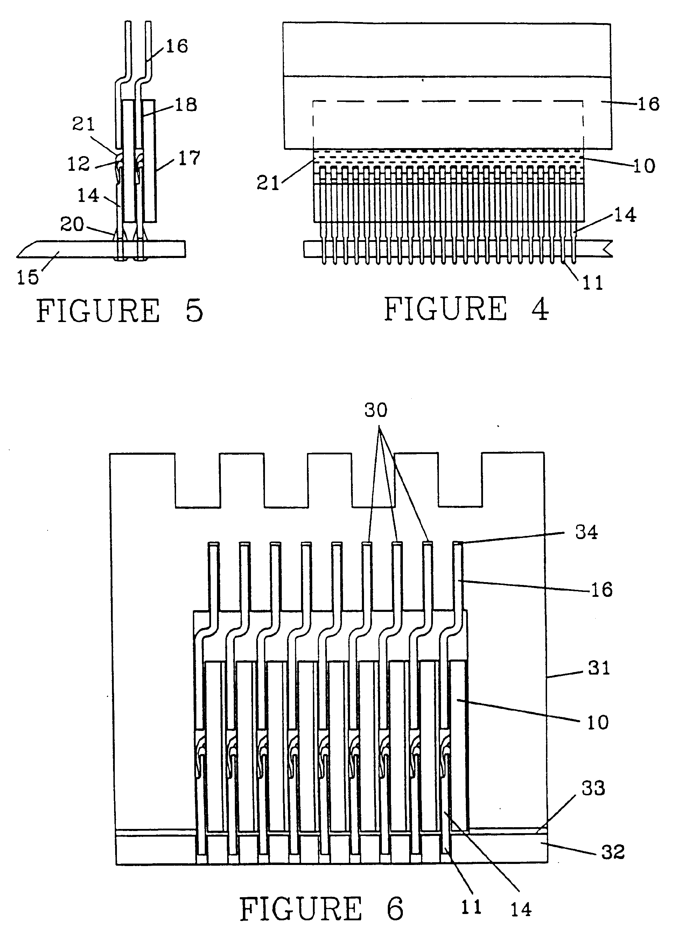

Figure 4 is a front view of a device mounted in a through-hole assembly. Device 10 has leads 14 attached thereto. Leads 14 have reduced area ends 11 which extend though the circuit board 15. Openings in the metalization on the circuit board extend through the circuit board, and, in some instances, the openings may be plated through the circuit board.

Figure 5 is a side view of the assembly of Figure 4. Solder 20 is shown formed around leads 14, reduced lead ends 11 and around the opening in the circuit board 15.

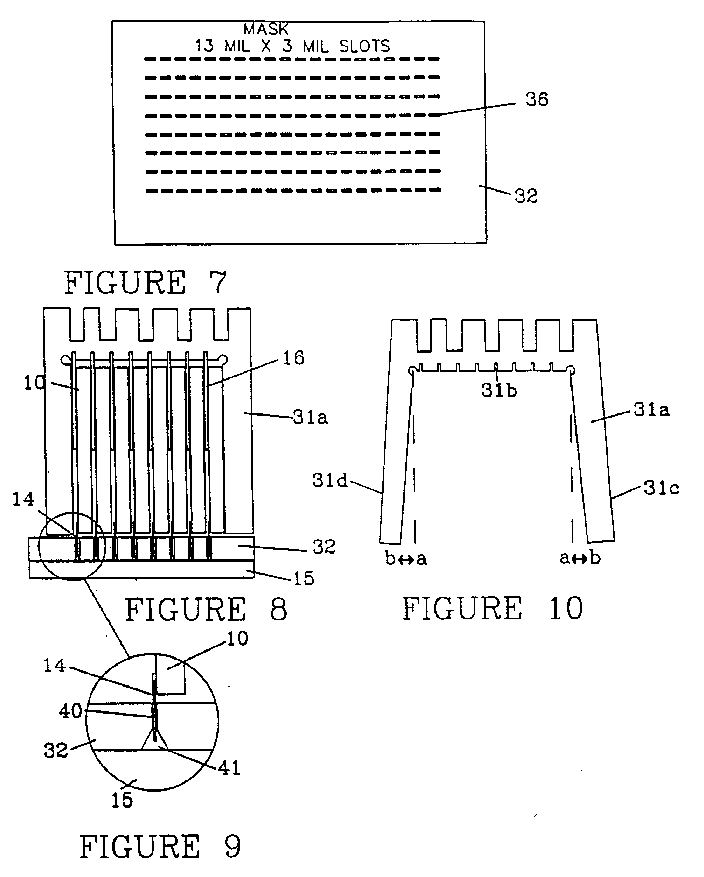

Figure 6 illustrates an array of devices mounted in a heat sink/holding fixture 31. To assembly an array 30 of devices 10, they may be mounted in heat sink/holding fixture 31 by placing the heat sink 16 of each device in a slot 34 in the top of the fixture. Also, the ends 11 of leads 14 may be inserted in a soldering mask 32, which, for example, may be of ceramic or other insulating material. Soldering mask 32 and fixture 31 may be bonded together by a high temperature adhesive 33. In the event the fixture 31 is not to remain over the device array, then fixture 31 may be removed after the leads 14 are soldered to a circuit board. However, the fixture 31 will generally be left over the array during testing and burn-in of the devices.

Figure 7 illustrates an example of a solder mask such as solder mask 32 shown in Figure 6. Solder mask 32 has, for example, an array of 8 rows, each row having twenty slots. The slots may, for example, be 0,33 mm (13 mils) by 0,076 mm (3 mils). This size slot easily accommodates leads having dimensions of 0,25 mm (10 mils) by 35 »m (1.4 mils), as used in TAB assemblies. The thickness of this mask is generally about 5,08 mm (.20 inch) or more.

Figure 8 is a cross-sectional view showing an array of eight devices 10 with leads 14 inserted in the solder mask 32. The solder mask can also be used as a fixture to hold the devices 10 during assembly of the array and soldering of leads 14 to a circuit board. A heat sink 31a holds the heat sinks 16 of each device and holds the devices for mounting in mask 32 on substrate 15.

Figure 9 is an enlargement of the portion of Figure 8 that is circled. Illustrated is device 10 having a lead 14 inserted in an opening 40 in mask 32. The opening in mask 32 is enlarged at 41 adjacent to circuit board 15. Solder is applied from the back side of mask 32 and squeezed into hole 41 until a menicus is formed. The assembly is then aligned to the pattern on the substrate and placed. Solder is reflowed in the opening to bond the end of lead 14 to circuit board 15. In the event a through-hole bond is used, then lead 14 would extend through circuit board 15 (not illustrated) without the use of the solder mask.

Figure 10 illustrates the heat sink 31a of Figure 8. Heat sink 31a may be sprung open for securing the heat sink 15 of each device in slot 31b. The legs 31c and 31d are opened or moved apart to insert the heat sinks 16 into slots 31b. Each leg 31c and 31d moves, for example for "a" to "b" when the legs are pulled apart. Upon release of legs 31c and 31d, the heat sinks and devices attached thereto are held in place between 31c and 31d.

The process of making the array package, from semiconductor die manufacturing to mounting an array on a circuit board is as follows.

After the semiconductor die containing the semiconductor device has been formed, a coating barrier metal, such as TiW and Pd, are sputtered or otherwise deposited on the bond pads on the semiconductor device. The back side of the wafer containing the semiconductor devices is coated with an insulating material such as polyimide, and then the wafer is sawed to separate the individual devices. Leads, such as leads 14 Figure 1, are mounted on the insulated surface of the device using a mounting material , such as an adhesive. Bond wires are attached to bond pad 13 and to lead 14. At this point in the process, the bond wire and connections are coated with polyimide to cover and protect the bond wire and connections. The lead frame is then trimmed and formed to produced the leads 14 and heat sink 16 (Figure 2). Instead of wire bonding, Tape Automated Bonding (TAB) may be used, as illustrated in Figure 3b.

The devices are then assembled into multiple device packages using a fixture such as illustrated in Figure 6. Thereafter the array of devices are subjected to tests and burn-in to identify, if any, faulty devices. Any bad devices from an array can be removed from the fixture and replaced with a good device from another array. A good device array is then placed on a circuit board and bonded by solder reflow to electrically connect the array to the circuit board.

The package of the invention provides heating sinking of the array, a fixture for testing and burn-in in module form, easy repair and replacement of devices, high density of devices, and the ability to inter-mix various semiconductor devices in a low cost assembly.

## Claims

1. A vertical lead-on-chip package for a high density array of semiconductor devices, comprising:
at least two integrated semiconductor devices (10,10) each having a plurality of leads (14) extending from one edge of the semiconductor device in a defined pattern;
a circuit board (15) having an array of contacts in a pattern which corresponds to the defined pattern of the plurality of leads; and
a removable fixture (31) for holding said at least two integrated circuit devices adjacent to each other in close proximity and placing the plurality of leads of each device in a pattern corresponding to the array of contacts on the circuit board.

2. The package according to claim 1, wherein said fixture (31) serves as a heat sink during testing and burn-in of the semiconductor devices and prior to soldering the plurality of leads to said circuit board, and after soldering the array of devices onto the circuit board.

3. The package according to claim 1, wherein the leads are bonded to the circuit board using surface mounting.

4. The package according to claim 1, wherein the leads are bonded to the circuit board using through-hole mounting.

5. The package according to claim 1, wherein the semiconductor device is coated on both sides with polyimide (17,18).

6. The package according to claim 1, wherein a solder mask (32) is used to hold the plurality of leads in a defined pattern during the application of solder paste onto the leads.

7. The package according to claim 1, wherein a solder mask (32) is used in conjunction with the heat sink to hold the semiconductor devices during solder reflow.

8. The package according to claim 1, including a solder mask (32) through which the plurality of leads extend.

9. The package according to claim 1, further including a heat sink (16) as part of said semiconductor package.

10. The package according to claim 1, including a heat sink (16) extending from an edge of said semiconductor device opposite said one edge.

11. The package according to claim 1, including a lead frame from which the leads and heat sink is formed.

12. A vertical lead-on-chip package for a high density array of semiconductor devices, comprising:
at least two integrated semiconductor devices (10,10) each having a plurality of leads extending from one edge of the semiconductor device in a defined pattern;
a circuit board (15) having an array of contacts in a pattern which corresponds to the defined pattern of the plurality of leads;
a heat sink (16) attached to each of said semiconductor devices; and
a removable fixture (31) for holding via said heat sink (16) each of said at least two integrated circuit devices adjacent to each other in close proximity, and placing the plurality of leads of each device in a pattern corresponding to the array of contacts on the circuit board.

13. A heat sink fixture for mounting an array of semiconductor devices in a package as claimed in claim 1 or in claim 12, comprising;
a U-shaped body;
a pair of legs (31c,31d) comprising a part of said U-shaped body that, when moved apart, return to original positions; and
a plurality of slots (31b) which, when the legs are moved apart, open to receive semiconductor devices, and secure the semiconductor devices in said slots when the legs are permitted to move to original positions.

## Patentansprüche

1. Chipbaustein zum vertikalen Auflöten für ein hochdichtes Feld von Halbleitervorrichtungen, mit:
wenigstens zwei integrierten Halbleitervorrichtungen (10, 10), die jeweils mehrere Anschlüsse (14) aufweisen, die von einem Rand der Halbleitervorrichtung aus in einem bestimmten Muster abstehen;
einer Leiterplatte (15) mit einem Feld. von Kontakten in einem Muster, welches dem bestimmten Muster der mehreren Anschlüsse entspricht; und
einer abnehmbaren Befestigungsvorrichtung (31), um die wenigstens zwei IC-Vorrichtungen in einem geringen Abstand voneinander zu halten und die mehreren Anschlüsse jeder Vorrichtung in einem Muster anzuordnen, das dem Feld der Kontakte auf der Leiterplatte entspricht.

2. Baustein nach Anspruch 1, bei dem die Befestigungsvorrichtung (31) während des Testens und Einbrennens der Halbleitervorrichtung sowie vor dem Verlöten der mehreren Anschlüsse mit der Leiterplatte und nach dem Verlöten des Feldes der Vorrichtungen auf der Leiterplatte als Kühlkörper dient.

3. Baustein nach Anspruch 1, bei dem die Anschlüsse unter Verwendung einer Oberflächenmontage mit der Leiterplatte verbunden sind.

4. Baustein nach Anspruch 1, bei dem die Anschlüsse unter Verwendung einer Durchkontaktmontage mit der Leiterplatte verbunden sind.

5. Baustein nach Anspruch 1, bei dem die Halbleitervorrichtung auf beiden Seiten mit Polyimid (17, 18) beschichtet ist.

6. Baustein nach Anspruch 1, bei dem eine Lötmaske (32) verwendet wird, um die mehreren Anschlüsse während des Aufbringens von Lötpaste auf die Anschlüsse in einem bestimmten Muster zu halten.

7. Baustein nach Anspruch 1, bei dem eine Lötmaske (32) in Verbindung mit dem Kühlkörper verwendet wird, um die Halbleitervorrichtungen während des Aufschmelzens des Lots zu halten.

8. Baustein nach Anspruch 1, enthaltend eine Lötmaske (32), durch die sich die mehreren Anschlüsse erstrecken.

9. Baustein nach Anspruch 1, ferner enthaltend einen Kühlkörper (16) als Teil des Halbleiterbausteins.

10. Baustein nach Anspruch 1, enthaltend einen Kühlkörper (16), der sich von einem Rand der Halbleitervorrichtung erstreckt, der zu dem besagten Rand entgegengesetzt ist.

11. Baustein nach Anspruch 1, enthaltend einen Anschlußrahmen, aus dem die Anschlüsse und der Kühlkörper gebildet sind.

12. Chipbaustein zum vertikalen Auflöten für ein hochdichtes Feld von Halbleitervorrichtungen, mit:
wenigstens zwei integrierten Halbleitervorrichtungen (10, 10), die jeweils mehrere Anschlüsse (14) aufweisen, die von einem Rand der Halbleitervorrichtung aus in einem bestimmten Muster abstehen;
einer Leiterplatte (15) mit einem Feld von Kontakten in einem Muster, welches dem bestimmten Muster der mehreren Anschlüsse entspricht;
einen Kühlkörper (16), der an jeder der Halbleitervorrichtungen (16) befestigt ist; und
einer abnehmbaren Befestigungsvorrichtung (31), um jede der wenigstens zwei IC-Vorrichtungen mittels des Kühlkörpers (16) in einem geringen Abstand voneinander zu halten und die mehreren Anschlüsse jeder Vorrichtung in einem Muster anzuordnen, das dem Feld der Kontakte auf der Leiterplatte entspricht.

13. Kühlkörperbefestigungsvorrichtung zum Anbringen eines Feldes von Halbleitervorrichtungen in einem Bauteil, wie es nach Anspruch 1 oder Anspruch 12 beansprucht ist, mit:
einem U-förmigen Körper;
einem Paar von Beinen (31c, 31d), die einen Teil des U-förmigen Körpers sind und, wenn sie auseinanderbewegt werden, in die Ausgangsstellungen zurückkehren; und
mehreren Schlitzen (31b), die, wenn die Beine auseinanderbewegt werden, sich öffnen, um Halbleitervorrichtungen aufzunehmen und diese Halbleitervorrichtungen in den Schlitzen zu sichern, wenn den Beinen ermöglicht wird, sich in die Ausgangsstellungen zurückzubewegen.

## Revendications

1. Boîtier de puce à connexions verticales pour un réseau à haute densité de dispositifs semiconducteurs, comprenant:
au moins deux dispositifs semiconducteurs intégrés (10, 10) ayant chacun une pluralité de conducteurs (14) s'étendant à partir d'un bord du dispositif semiconducteur selon une configuration définie;
une carte (15) à circuits imprimés ayant un réseau de contacts selon une configuration qui correspond à la configuration définie de la pluralité de conducteurs; et
une fixation amovible (31) pour maintenir lesdits au moins deux dispositifs à circuit intégré adjacents l'un à l'autre à proximité immédiate et pour placer la pluralité de conducteurs de chaque dispositif selon une configuration correspondant au réseau de contacts sur la carte à circuits imprimés.

2. Boîtier selon la revendication 1, dans lequel ladite fixation (31) sert de puits de chaleur au cours des essais et du vieillissement des dispositifs semiconducteurs et avant de souder la pluralité de conducteurs à ladite carte à circuits imprimés, et après la soudure du réseau de dispositifs sur la carte à circuits imprimés.

3. Boîtier selon la revendication 1, dans lequel les conducteurs sont reliés à la carte à circuits imprimés en utilisant un montage de surface.

4. Boîtier selon la revendication 1, dans lequel les conducteurs sont reliés à la carte à circuits imprimés en utilisant un montage à trou traversant.

5. Boîtier selon la revendication 1, dans lequel le dispositif semiconducteur est recouvert des deux côtés par du polyimide (17, 18).

6. Boîtier selon la revendication 1, dans lequel un masque (32) de soudure est utilisé pour maintenir la pluralité de conducteurs selon une configuration définie au cours de l'application de pâte de soudure sur les conducteurs.

7. Boîtier selon la revendication 1, dans lequel un masque (32) de soudure est utilisé en conjonction avec le puits de chaleur pour maintenir les dispositifs semiconducteurs au cours de la refusion de la brasure.

8. Boîtier selon la revendication 1, comportant un masque (32) de soudure à travers lequel s'étend la pluralité de conducteurs.

9. Boîtier selon la revendication 1, comportant en outre un puits de chaleur (16) faisant partie dudit boîtier de semiconducteur.

10. Boîtier selon la revendication 1, comportant un puits de chaleur (16) s'étendant depuis un bord dudit dispositif semiconducteur à l'opposé dudit premier bord.

11. Boîtier selon la revendication 1, comportant une grille de connexion à partir de laquelle les conducteurs et le puits de chaleur sont formés.

12. Boîtier de puce à connexions verticales pour un réseau à haute densité de dispositifs semiconducteurs, comprenant:
au moins deux dispositifs semiconducteurs intégrés ayant chacun une pluralité de conducteurs s'étendant depuis un bord du dispositif semiconducteur selon une configuration définie;
une carte (15) à circuits imprimés ayant un réseau de contacts selon une configuration qui correspond à la configuration définie de la pluralité de conducteurs;
un puits de chaleur (16) fixé à chacun desdits dispositifs semiconducteurs; et
une fixation amovible (31) pour maintenir par l'intermédiaire dudit puits de chaleur (16) chacun desdits au moins deux dispositifs à circuit intégré adjacents l'un à l'autre à proximité immédiate, et pour placer la pluralité de conducteurs de chaque dispositif selon une configuration correspondant au réseau de contacts sur la carte à circuits imprimés.

13. Fixation de puits de chaleur pour le montage d'un réseau de dispositifs semiconducteurs dans un boîtier tel que revendiqué dans la revendication 1 ou dans la revendication 2, comprenant
un corps en forme de U;
une paire de pattes (31c, 31d), comprenant une partie dudit corps en forme de U, qui, lorsqu'elles sont écartées, retournent dans leurs positions originales; et
une pluralité de fentes (31b) qui, lorsque les pattes sont écartées, s'ouvrent pour recevoir des dispositifs semiconducteurs, et fixent les dispositifs semiconducteurs dans lesdites fentes lorsque les pattes peuvent se déplacer vers leurs positions originales.
